# EUROPEAN PATENT APPLICATION

(11) **EP 3 914 051 A1**
(43) Date of publication of application: **24.11.2021**
(21) Application number: 20382433.9
(22) Date of filing: 21.05.2020
(51) Int. Cl.: H05K 1/02, H05K 1/09, H05K 3/12, H05K 3/28

(54) **METHOD FOR MANUFACTURING AN ELECTRONIC ASSEMBLY ON A 3D PART**

(71) Applicant: Fundación Tecnalia Research & Innovation, 20009 Donostia - Guipuzcoa (ES)
(72) Inventor: Obieta Vilallonga, Isabel, 20009 Donostia - Guipúzcoa (ES); Bustero Martinez de Zuazo, Izaskun, 20009 Donostia - Guipúzcoa (ES); Bilbao Alba, Leire, 20009 Donostia - Guipúzcoa (ES); Vaquero Moralejo, Celina, 20009 Donostia - Guipúzcoa (ES); Maudes Puentedura, Jon, 20009 Donostia - Guipúzcoa (ES)
(74) Representative: Balder IP Law, S.L.

(57) **Abstract**

A method of applying an electronic assembly on a 3D part made of a polypropylene-based material, the electronic assembly comprising at least one electrically conductive path having width between 0.1 and 4 mm, the method comprising: providing a 3D part made of a polypropylene-based material; selecting a conductive paste (128) comprising: metallic particles comprising silver, a binder and an organic solvent; the amount of binder being between 1 to 5 wt%; the amount of metallic particles being between 74 to 90 wt%, the metallic particles having an average size between 50nm to 50µm; wherein the viscosity of the conductive paste is between 75 and 425 Pa-s measured with a rheometer at a temperature of 25°C at 1/s shear rate; providing a fluid dispensing system (11) for applying the conductive paste (128) onto a surface of the 3D part; selecting and attaching a nozzle (125) to the fluid dispensing system (11), through which the selected conductive paste is to be dispensed, wherein the nozzle (125) is selected such that its inner diameter is as close as possible to the width of the conductive path to be applied, the inner diameter of the nozzle (125) being smaller than the width of the conductive path to be applied; dispensing the selected conductive paste (128) on to the surface of the 3D part through said nozzle (125) by applying a pressure between 0.2 and 13 bar, while maintaining a maximum distance of 900 µm between the nozzle (125) and the surface of the 3D part; curing the deposited conductive paste; depositing a dielectric ink on the printed conductive path; curing the deposited dielectric ink; attaching at least one electronic component on the conductive path.

## Description

### TECHNICAL FIELD

The present invention relates to the field of injection molded parts or machined parts. In particular, it relates to methods and systems for obtaining 3D injection molded parts or 3D machined parts accommodating electronics, for example providing at least an electrical contact pad to the part, coupling an electrically conductive member to the electrical contact pad and/or including any other electronic component.

### STATE OF THE ART

In many fields of technology, and due to different reasons, electronics and related products are usually integrated into different substrates. Exemplary reasons for such integration may be volume and/or weight savings and efficient integration of components. Exemplary fields of technology aiming at integrating electronics on different substrates are product packaging, product housings, personal electronic devices, wearable electronics, displays, toys, electrical household appliances and transport industry, including automotive and aeronautics industry. In many fields, integration is a key aspect. For example, in the field of automotive industry, integration is essential both in vehicle exteriors and vehicle interiors (e.g. control panels, dashboards, seats, door panels, etc.).

There exist different techniques for providing functionalities -such as electronic components, integrated circuits and conductors- onto a substrate element. Printed electronics or functional printing covers screen printing, flexography and inkjet printing, among others, through an additive printing process. Functional printing is the use of active materials to perform tasks combining mechanical and electrical/electronic functionalities, including integrated elements like lighting or photovoltaics. Functional printing activities are typically performed on a planar (2D) substrate, either flexible or not. Examples of substrates typically used are PET, PC, textiles and paper.

In certain applications, however, the substrate on which electronics and related products have to be integrated is a three-dimensional (3D) structure, and therefore the integration of electronics becomes more complicated, to the extent that nowadays there is no optimized solution to the challenge of integrating structural electronics in 3D parts. Structural electronics is rapidly entering the marketplace using lamination, conformal films, 3D printing or in-mould electronics.

US2020031041A1 discloses a method for 3D printing a conductive circuit on a part while the part is being manufactured. In particular, a 3D structural material is printed by applying layers of a phase change material and a metal nanoparticle ink composition is deposited on the 3D structural material.

US10408391B2 discloses a method for manufacturing a multilayer structure having integrated electronics. The method includes printing electrically conductive traces on a flexible substrate film layer, after which the substrate layer is 3D-shaped through thermoforming. Then, a thermoplastic is molded onto a side of the film layer. However, this method shows some limitations in terms of 3D geometries and suitable materials. First, only flexible substrates capable of supporting thermoforming can be used. Second, only moldable inks are suitable for thermoforming. In fact, even if a flexible substrate and a moldable ink are used, there is a limitation in the targeted 3D geometry to be obtained, since no moldable ink supports deformations in angles higher than 85° and by thermoforming simple curvature parts can be obtained, together with limited design freedom in the depth of the thermoformed part and in the materials to be over-injected. Therefore, this method is limited to 3D parts having regular shapes, with no sharp three-sided corners. The radius at the bottom of the part is most critical. The deeper the part the larger the radius or chamfer required, because thermoforming requires rounded shapes rather than sharp ones. Third, electronic components can only be embedded up to a certain depth. Moreover, deformation from flat to an irregular shape implies that the circuit is elongated (stretched) or compressed, needing specific designs taking into account the deformations that will be carried out. In addition to these deformations, high temperatures and pressures damage rigid components. And finally, the process is complex and time consuming, since it involves different equipment (screen printing, thermoforming and over injection moulding, among others).

In addition to the former drawbacks, in several sectors, such as the automotive industry, it is desirable to perform the printed electronics process on a 3D injection-molded part, in order not to alter well-established manufacturing processes. In other words, certain sectors in which 3D parts are injection-molded may be reluctant to modify their production lines with the sole goal of thermoforming flat flexible substrates in order to embed electronic structures prior to obtaining 3D parts. For example, US7833567B2 discloses a method for forming an electric circuit on a door trim panel. The method includes intermittently jetting molten metal against the door trim panel to define rows of metal grains so as to deposit the molten metal to form the electric circuit. However, it has been observed that depositing molten metal on an injection-molded part has several drawbacks. For example, the adhesion of metal on substrates like polypropylene (PP) is extremely low and there is an important mismatch in the coefficient of thermal expansion (19-20(m/m)/°C) of certain metals (for example silver) versus 70-90(m/m)/°C) of the unfilled PP). Besides, the need of high temperature for sintering in order to obtain high electrical conductivities is not appropriate for most of the plastics being targeted in the automotive sector. Finally, when molten metal jetting is applied, it is difficult to control the line resolution because it depends on the drop size.

In turn, US10276937B2 discloses a method of forming a conductive trace on to a substrate by jet dispensing from a certain distance drops of ink with a jet dispenser having a valve enabling high frequency drop generation. However, delivering discrete ink drops requires an accurate control of the ink viscosity, as acknowledged in US10276937B2: while inks having high viscosity tend to accumulate at the nozzle tip, which may eventually break free from the nozzle as a large mass, creating a random walk pattern, too many drops of ink having low viscosity result in a spray of satellite drops around the central drop, resulting in a non-well defined geometry. In order to overcome this, the viscosity of the conductive ink must be measured prior to starting the printing process and, if the ink viscosity is greater than 2.0 Pa-s, either a fluid is added to the ink in order to reduce its viscosity, or another ink is selected. In other words, the method disclosed in US10276937B2 is limited to a short collection of ink types, as a consequence of which it is also limited to printing certain geometries.

Therefore, there is a need to develop an alternative method of obtaining 3D parts having electronic assemblies, that does not pose the mentioned limitations. There is also a need to obtain 3D parts having electronic assemblies, such as conductive paths, circuits, electronic components, sensors, etc., obtained without needing to alter the conventional process of injection molding manufacturing or machining.

### DESCRIPTION OF THE INVENTION

The method for obtaining 3D parts having electronic assemblies, and the 3D parts having electronic assemblies, described in the present invention, intend to solve the shortcomings of prior-art methods and systems therefor.

The method of the invention permits to print electronic assemblies on the injection molded part made of a PP-based material. Electronic assemblies comprise conductive paths or circuits. Electronic assemblies may additionally include one or more of the following elements: dielectric protection applied on conductive paths or circuits, electronic components (such as electric contact pads added to conductive paths or circuits, electrically conductive members coupled to electric contact paths, sensors, etc.). For printing these elements, different types of fluids are required. For example, conductive ink, dielectric ink and adhesive are typically needed.

For example, in order to print an electronic assembly comprising a lighting device with an on/off button based on a capacitive sensor, in a part made of a PP-based material, to be integrated in a car door or in a dashboard, the following steps will be carried out. First, a prototype must be designed, including designing an electrical circuit drawn for example in CAD. Then, the electrical paths and a capacitive button must be printed with a conductive ink. The conductive ink must be cured, usually by a thermal process. This process must be repeated for each side of PP part to be printed. In order to protect and isolate the printing performed with conductive ink, a dielectric film must be printed on the electrical circuit. To ensure a good coverage of the conductive paths, the width of the dielectric cover must preferably be larger than the width of the conductive paths and capacitive button except where components have to be placed. When the electric circuit is covered and the dielectric ink is cured, components, such as LEDs and connector, can be placed. These components must be glued to the device by a conductive adhesive ink. Measured beads of the adhesive ink are printed on specific points in the conductive paths where the LEDs or connector will be finally placed. Optionally, a film encapsulating the former assembly may be applied, for example by lamination or film adhesion.

The method of the present invention finds special advantages in the transport industrial sector, including automotive and aerospace sector, because in these sectors it is definitely desirable to manufacture injection-molded parts or machined parts having electric structures printed thereon, while performing both steps (injection molding or machining of the part and printing the electric structure) in a same manufacturing process, in which printing the electronic circuit or the like is accomplished as an additional step performed on the injection molded or machined manufactured part. In other words, the injection molding or machining process does not need to be modified because the printing occurs directly on the finished part.

For this reason -because the printing of the electric structure is performed on an injection molded or machined part, there is a need to adapt to materials with which the parts are made. For example, in the automotive sector, injection molded parts are made of a polymeric material having low surface energy. The polymeric material is preferably a polypropylene (PP)-based material. The PP-based material can be either unfilled or filled with common fillers like talc, short glass fibres or others.

The electronic assembly is directly printed on the finished part using functional inks by applying a fluid dispensing technique (also referred to as micro-dispensing), in which beads of ink, such as conductive paste, form a filament when they are continuously deposited on the surface of the 3D part. The printing process is performed using a robot or robotic system that may handle different types of printing modules using different heads (fluid dispensers) with corresponding dispensing nozzles, through which a material, such as functional ink or adhesive, is applied, and curing modules to sinter the inks. In the context of the present invention, the expression functional ink (or simply "ink") refers to conductive, dielectric or sensing ink. In turn, adhesive is used for attaching certain components, such as connectors or discrete components, to the part. The robotic system may have one or more heads. The fluid dispensers can handle a wide range of fluids to dispense dots, beads or cords (continuous filaments) by properly matching the viscosity of the fluid with the inner diameter of the nozzle and with the pressure and speed applied during dispensing. Valves are specially relevant in controlling the pressure for a perfect control of the dispensed fluid. The speed applied during dispensing may also be matched with the fluid viscosity, inner diameter of the nozzle and applied pressure.

When the robotic system has a single head, a different syringe assembly and corresponding dispensing tip is used for printing a respective layer of the electronic assembly. In this case, syringe assemblies and dispensing tips are replaced every time a new layer of ink (or adhesive) has to be applied. When the robotic system has several heads, each head has a different syringe assembly and corresponding dispensing tip or curing module attached thereto, so that there is no need to interrupt the printing process every time a new printing layer (and therefore a new syringe assembly, fluid and dispensing tip or curing module) should be printed or applied. The robotic system may also have one or more pick&place heads for positioning non-printed components, such as lamps (e.g. LEDs), connectors, sensors or other components. The robot or robotic system may also have one or more curing heads for in-situ curing the applied functional ink or adhesive.

The 3D PP-based part may have any shape, including single curvature surfaces, which are curved on one linear axis and are part of a cylinder or cone (for example linear or cylindrical surfaces), and double curvature surfaces, which are either part of a sphere or a hyperboloid of revolution. The outer surface of the 3D part may have geometrical irregularities, such as cavities, pores, grooves, channels, or any other irregularity, such as an ornamental pattern. The electronic assembly can be printed on the 3D part even if the surface of the 3D part has high roughness. In fact, certain roughness of the PP-based surface may help improve adhesion due to an increased contact surface.

Printing electrical conductive structures on a part made of a polypropylene-based material must face several difficulties. In particular, two important surface characteristics need to be controlled: adhesion and wettability (surface energy). Regarding adhesion, factors affecting adhesion are the composition of the polymeric substrate (polymer itself and eventual fillers and/or additives), the molding process, the surface conditions (including roughness), and the storage and handling. Adhesion has been tested using different PP-based materials having different grades and having different fillers. Polymeric substrates made of PP-based material do not show good adhesion with a great deal of conventional inks. In particular, conventional functional inks have low adhesion to PP-based materials with respect to their adhesion to other materials, such as PC or PMMA. One of the reasons for such poor adhesion is the low polarity of the material.

Regarding wettability, factors affecting wettability (surface energy) are the composition of the polymeric substrate (polymer itself and eventual fillers and/or additives) and the surface roughness, dependent in turn on the mould finishing. In this sense, using parts having high surface roughness is desirable. However, in certain fields, such as the automotive field, the standard manufacturing process of injection molded parts must not be altered at all. For this reason, the surface finish of the mould cannot be modified in order to enable (or contribute to) the later printing of an electric conductive structure. The method of the present invention adapts to the actual roughness of the surface of the part.

Because the different factors affecting adhesion and wettability of the printing process on the injection molded part cannot be controlled (because they form part of a well-established manufacturing process), inventors have realized that a specific type of conductive ink must be used for the printing of the electrically conductive structure. The ink (also referred to as low-temperature dryable conductive paste) used in the present invention comprises metallic particles comprising silver, a binder (also referred to as binding agent) and an organic solvent. One or more additives may be optionally included in the ink as well.

The surface tension of the ink is preferably less than the substrate surface energy, preferably with a difference of 2-10 mN/m (in practice around 10 mN/m) in order for the ink to spread out and wet the substrate, thus achieving an intimate contact necessary for good adhesion. The selected ink must therefore guarantee such good adhesion.

A first aspect of the invention relates to a method of applying an electronic assembly on a 3D part made of a polypropylene-based material, the electronic assembly comprising at least one electrically conductive path having width between 0.1 and 4 mm, the method comprising: providing a 3D part made of a polypropylene-based material; selecting a conductive paste comprising: metallic particles comprising silver, a binder and an organic solvent; the amount of binder being between 1 to 5 wt%; the amount of metallic particles being between 74 to 90 wt%, the metallic particles having an average size between 50nm to 50µm; wherein the viscosity of the conductive paste is between 75 and 425 Pa-s measured with a rheometer at a temperature of 25°C at 1/s shear rate; providing a fluid dispensing system for applying the conductive paste onto a surface of the 3D part; selecting a nozzle and attaching the selected nozzle to the fluid dispensing system, through which the selected conductive paste is to be dispensed, wherein the nozzle is selected such that its inner diameter is as close as possible to the width of the conductive path to be applied, the inner diameter of the nozzle being smaller than the width of the conductive path to be applied; dispensing the selected conductive paste on to the surface of the 3D part through said nozzle by applying a pressure between 0.2 and 13 bar, while maintaining a maximum distance of 900 µm between the nozzle and the surface of the 3D part; curing the deposited conductive paste; depositing a dielectric ink on the printed conductive path; curing the deposited dielectric ink; attaching at least one electronic component on the conductive path.

In embodiments of the invention, when the viscosity of the selected conductive paste is between 75 and 105 Pa-s, the selected conductive paste is dispensed on to the surface of the 3D part as follows: if the inner diameter of the selected nozzle is between 0.1 and 0.3 mm, applying a pressure on the conductive ink between 3 and 1 bar; if the inner diameter of the selected nozzle is between 0.3 and 1 mm, applying a pressure on the conductive ink between 1 and 0.3 bar; if the inner diameter of the selected nozzle is between 1 and 4 mm, applying a pressure on the conductive ink between 0.3 and 0.2 bar.

In embodiments of the invention, when the viscosity of the selected conductive paste is between 105 and 260 Pa-s, the selected conductive paste is dispensed on to the surface of the 3D part as follows: if the inner diameter of the selected nozzle is between 0.1 and 0.3 mm, applying a pressure on the conductive ink between 7 and 2 bar; if the inner diameter of the selected nozzle is between 0.3 and 1 mm, applying a pressure on the conductive ink between 2.5 and 0.4 bar; if the inner diameter of the selected nozzle is between 1 and 4 mm, applying a pressure on the conductive ink between 0.5 and 0.3 bar.

In embodiments of the invention, when the viscosity of the selected conductive paste is between 260 and 425 Pa-s, the selected conductive paste is dispensed on to the surface of the 3D part as follows: if the inner diameter of the selected nozzle is between 0.1 and 0.3 mm, applying a pressure on the conductive ink between 13 and 3 bar; if the inner diameter of the selected nozzle is between 0.3 and 1 mm, applying a pressure on the conductive ink between 3 and 0.8 bar; if the inner diameter of the selected nozzle is between 1 and 4 mm, applying a pressure on the conductive ink between 0.8 and 0.4 bar.

In embodiments of the invention, the dielectric ink is a polymeric dielectric ink comprising at least one of: poly (4-vinylphenol) (PVP), poly (methyl methacrylate), Polyethylene Terephthalate, polyimide, Polyvinyl alcohol and Polystyrene.

In embodiments of the invention, the at least one electronic component is adhered by means of an adhesive deposited on a corresponding position on the conductive path.

In embodiments of the invention, the at least one electronic component is one of a LED, a cable, a connector and a sensors.

In embodiments of the invention, the binder comprised in the conductive paste is based on a polymeric resin.

In embodiments of the invention, the conductive paste is deposited with an angled-tip nozzle.

In embodiments of the invention, the deposited conductive paste is cured in an oven at a temperature of 130°C-170°C for between 5 minutes and 1,5 h.

In embodiments of the invention, the deposited conductive paste is cured using an IR lamp.

In embodiments of the invention, the deposited dielectric ink is cured using an UV lamp for 20-60 seconds.

In embodiments of the invention, the polypropylene-based material is one of the following: a thermoplastic polyolefin (TPO); a PP copolymer; a colored PP; an Engineering-filled polypropylene (EFPP); a new generation of PP; and a PP-glass fibre composite.

The proposed method can work with a great variety of inks, which enables to obtain a great variety of electronic assemblies on a great variety of geometries.

Additional advantages and features of the invention will become apparent from the detailed description that follows and will be particularly pointed out in the appended claims.

### BRIEF DESCRIPTION OF THE DRAWINGS

To complete the description and in order to provide for a better understanding of the invention, a set of drawings is provided. Said drawings form an integral part of the description and illustrate an embodiment of the invention, which should not be interpreted as restricting the scope of the invention, but just as an example of how the invention can be carried out. The drawings comprise the following figures:
Figure 1 schematically shows a robotic system for performing functional printing on an injection molded part according to an embodiment of the invention.
Figure 2 schematically shows a portion of a robotic system for performing functional printing on an injection molded part according to an alternative embodiment of the invention.
Figure 3 schematically shows a portion of a robotic system for performing functional printing on an injection molded part according to an alternative embodiment of the invention.
Figure 4 schematically shows a printing assembly according to an embodiment of the invention.
Figure 5 schematically shows another robotic system for performing functional printing on an injection molded part according to an embodiment of the invention.
Figures 6a, 6b, 7a, 7b, 7c, 8a and 8b show 3D parts obtained through an injection molding process or machining process and used in the automotive and/or aeronautic sector.

### DESCRIPTION OF A WAY OF CARRYING OUT THE INVENTION

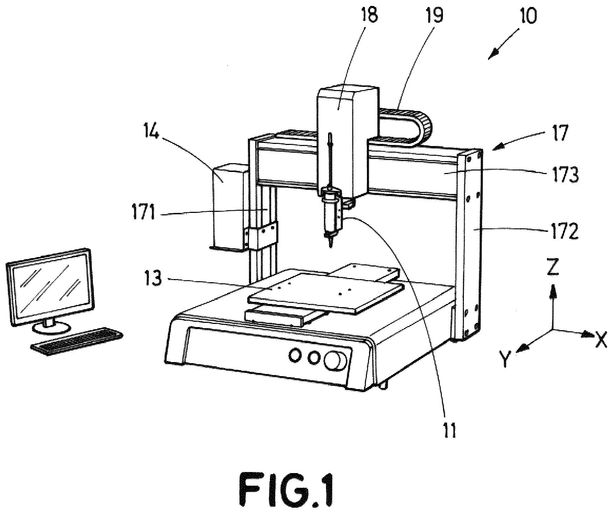

Figure 1 schematically shows a robot or robotic system 10 that can be used in a method for obtaining a 3D part having an electrical conductive structure thereon, according to the present invention. The part can be a complex 3D part, for example having single or double surface curvatures. The 3D part may be obtained through a conventional injection molding or machining manufacturing process. The part (injection molded or machined) is made of a polymeric material having low surface energy. The polymeric material is preferably a polypropylene (PP)-based material. The PP-based material can be either unfilled or filled with common fillers like talc, short glass fibres or others. Non-limiting examples of PP-based materials of which the injection molded part may be made of, are: thermoplastic polyolefins (TPO); PP copolymers; colored PP; Engineering-filled polypropylene (EFPP); new generations of PP (also referred to as new generation grades); and PP-glass fibre composites with different amounts of glass fibre, such as between 1-40% in weight of glass fibre, for example between 2-40% or between 10-40%.

For example, but not limiting, TPO are usually employed for molding certain vehicle parts, such as bumper fascia, side still, mudguards, and protective molding. PP copolymers are usually employed for molding certain vehicle parts, such as battery cases and bumpers. Colored PP is usually employed for molding certain vehicle parts, such as door panel, pillar, trim and lamp housing. EFPP is usually employed for molding certain vehicle interior components, such as pillar, consoles, armrest, etc.; heater housings; air cleaner bodies; and other interior component with improved aesthetics, dashboard components, bumpers, plugs, engine fans, wheel house trims, steering wheel covering, one-piece dash boards, cowl linkage cover, trim panels, radiator headers, engine fan, heater baffles, etc. PP-glass fibre composites are usually employed for molding certain vehicle parts, such as front-end modules, battery supports, gearshift housing/support, instrumental panel (IP) carriers, body panel reinforcements, underbody aerodynamic covers, electronic boxes, pedals and their supports, door panel carriers and door modules, bumper beams, fender extensions, wheel covers, hub caps, lamp housings, grills, under-the-hood reservoir, and trim rings for wheels. As a matter of example, dashboard, bumpers and some exterior trims may be made of a PP-glass fibre composite having between 10 and 30% in weight of glass fibre; bumpers, spoilers, and side protective strips may be made of a PP-glass fibre composite having around 20% in weight of glass fibre; certain automotive interior parts including dashboard, and certain exterior parts, including the bumpers system and other exterior trims, may be made of a PP-glass fibre composite having between 30 and 40% in weight of glass fibre; and fan blades, head lamp housing, and belt covers may be made of a PP-glass fibre composite having around 30% in weight of glass fibre.

The part surface may have a minimum roughness equivalent to the so-called mirror-polished mould, and a maximum roughness (average roughness) of up to several hundreds of microns (10⁻⁶ m), such as up to 500 µm. When designing the electrical circuit, the roughness of the surface of the target PP-based substrate must be taken into account.

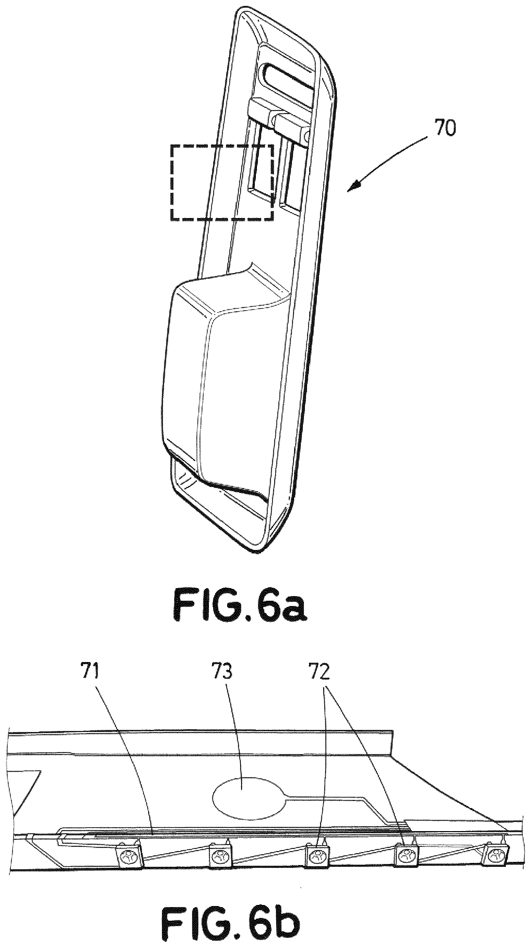

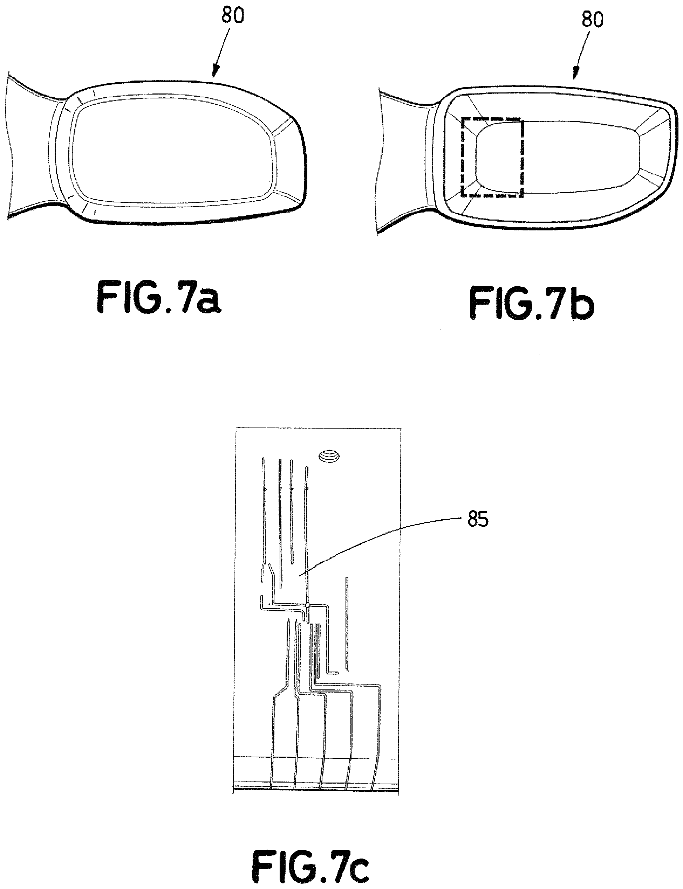

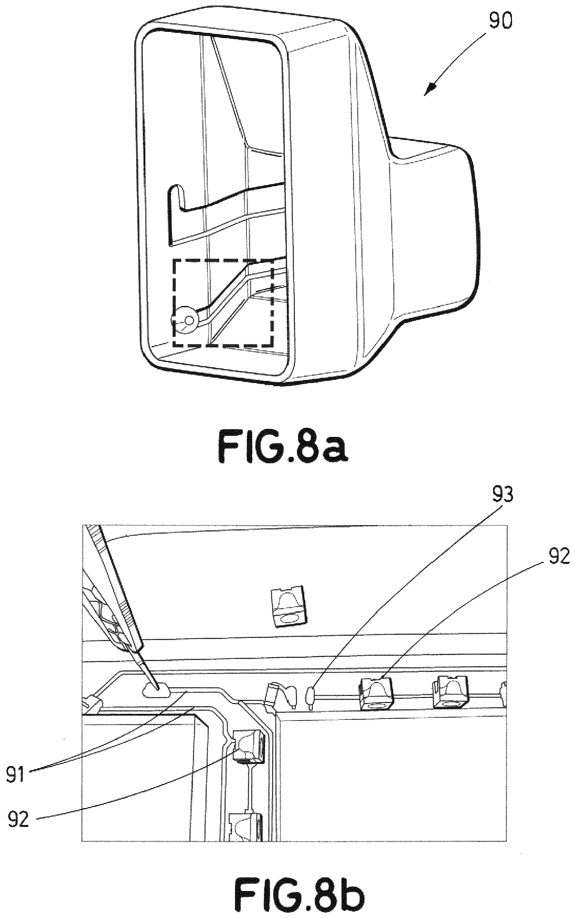

Figures 6a, 7a-7b and 8a show examples of injection molded 3D parts used for example in the automotive and/or aeronautic sector. Figure 6a shows a door bezel 70 made of a PP-glass fibre composite having 16% talc. Figures 7a-7b show two views of a rear-mirror view bracket 80 made of a PP-glass fibre composite having 24% (%w) short glass fibre. Figure 8a shows a headlight housing part 90 made of a PP-glass fibre composite having 20% short glass fibre. The injection molded or machined part (not shown in Figure 1) may be placed on a plate 13. Robotic system 10 is used to apply functional ink by fluid dispensing -preferably micro-dispensed- on the part. It may also be used to apply an adhesive in order to attach certain components to the part.

The robotic system 10 has a controller 14. Controller 14 has processing means, such as one or more processors or microprocessors. For example, controller 14 may be implemented in a personal computer (PC) having at least one central processing unit (CPU). One or more human-machine interfaces (HMI) may be used as interface between the controller 14 (and the software embedded therein) and an operator. Non-limiting examples of HMI may be a monitor, a keyboard, a mouse, or the like. Controller 14 comprises memory means in which the design of an electronic assembly (i.e. trajectories to be followed by one or more printing heads), are stored. The trajectories to be printed are introduced, for example, by means of a CAD design. An electronic assembly printing process implies that different inks must be used, such as conductive ink, dielectric ink (to protect and isolate the conductive paths), and optionally adhesive to glue electronic components. Each fluid (ink, adhesive) involves a different process step and therefore a different design (i.e. CAD design) must be introduced for each fluid (in other words, for each printing layer). The coordinates defining the 3D shape of the part are also stored. A specific software for comparing the current location of the part with respect to a reference location thereof (for example stored as an image file in memory means) may also be embedded in controller 14. The robotic system 10 has at least three axis (three DoF, degrees of freedom). In the case of 3 DoF, as is the case of the robotic system 10 in Figure 1, (x, y, z) points, corresponding to the trajectory to be followed by the printing head, are provided to the robotic system, in particular to controller 14, which in turn controls the movement of the printing head. The amount of (x, y, z) points to be provided depends on the complexity of the part.

Robotic system 10 may have a plate 13, such as a fixture plate, on which the part on which an electronic assembly is going to be printed, may be disposed. Robotic system 10 also comprises a support 17, which is an electro-mechanical structure for supporting components of the robotic system 10 and for enabling relative movement between the printing head and the part.

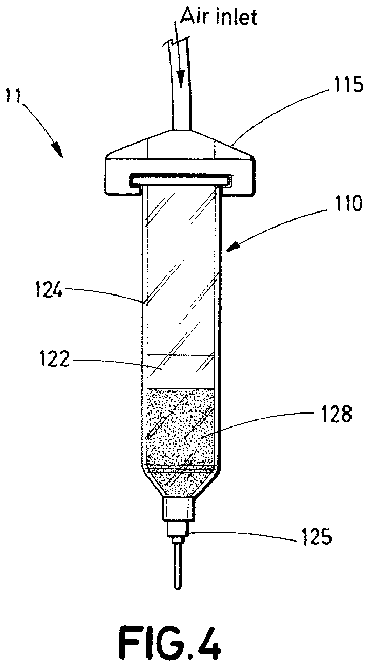

Support 17 may be implemented with at least one elongated portion (vertical beam) 171 disposed perpendicular with respect to the surface on which the part is to be placed (i.e. plate 13), and one elongated portion 173 (horizontal beam) perpendicularly projecting from the upper end of elongated part 171. Parallel to the elongated portion 171, there may be a second elongated portion 172, the upper end of which is attached to the end of portion 173 not attached to portion 171. In this configuration, support 17 substantially takes the shape of an inverted U. A cartridge 18 is slideably attached to horizontal beam 173. Cartridge 18 can move along the horizontal beam 173, that is to say, along X axis (i.e. horizontally). The movement of cartridge 18 is enabled by a flexible cable 19. Cartridge 18 carries a printing assembly (also referred to as printing head or fluid dispensing system) 11 comprising a syringe, a printing tip (nozzle) and other elements involved in a printing process. Thus, when cartridge 18 slides along the horizontal beam 173, printing assembly 11 moves in the X axis. In Figure 1, plate 13 is movable in Y-axis (backwards and forwards). The printing assembly 11 is attached to a support in turn coupled to the cartridge 18. The support on which the printing assembly 11 is attached is vertically movable (in the Z axis), so that the printing assembly 11 comes closer to or further from the 3D surface of the part disposed on the plate 13. Therefore, with the combination of the cartridge 18 movement along the horizontal beam 173, the vertical movement of the printing assembly support and the movement of the plate 13, the (x, y, z) positions ordered by controller 14 in order to follow the required printing trajectories, are reproduced. An exemplary printing assembly 11 is explained in detail with reference to Figure 4.

In a particular embodiment, the robotic system 10 may include a sensing means (not shown in Figure 1) for example attached to the printing assembly 11 to measure the actual distance (Z axis) between the tip of the printing assembly and the surface of the part. Non-limiting examples of such sensing means are a laser sensor or a camera. In this embodiment, the sensing means moves while printing assembly 11 moves, in such a way that while the surface of the part disposed on the plate 13 is sensed, the height (Z-axis) of the part is captured. Manual correction of the height (Z axis) may be then performed based on the capture, so that the part can be aligned with the printing.

In another particular embodiment, the robotic system 10 may include a scanner (not shown in Figure 1) which moves while printing assembly 11 moves, in such a way that while the surface of the part disposed on the plate 13 is scanned, (x,y,z) points measured on the part surface are fedback to the controller 14, so that the defined trajectory can be adjusted if necessary. The control software may use reference points to automatically adjust to small changes in the orientation and location of the part disposed on the plate 13. It may also adjust the program (software) controlling the amount of ink to be dispensed, depending on such changes in orientation and location of the part. For example, if a difference in the X and Y positions or in the angle of rotation of the part (in the event such rotation is variable), is detected, it automatically adjusts the dosing path to correct the difference. High positional accuracy is thus obtained. The robotic system may have more than three axis (DoF), such as 4 axis (DoF) or 5 axis (DoF).

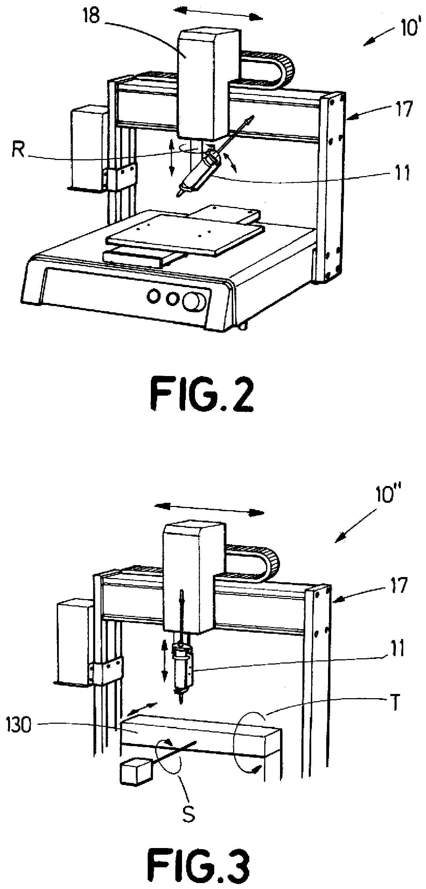

Figure 2 shows an alternative robotic system 10'. Robotic system 10' is similar to robotic system 10, but has 4 DoF instead of 3 DoF. In particular, in addition to the X, Y, Z movements enabled by robotic system 10, robotic system 10' includes a rotation movement in the printing assembly (for example in particular in the syringe). Figure 3 shows another alternative robotic system 10". Robotic system 10" has 5 DoF. In particular, in addition to the X, Y, Z movements enabled by robotic systems 10, 10', robotic system 10" includes a rotation movement S and a tilting movement T in the part. In other words, the part can be rotated S and tilted T. In order to achieve the fourth and fifth DoF, the plate 13 in robotic system 10 is replaced with a lower beam 130, which is configured to rotate between 0 and 180°.

Figure 4 shows a fluid dispensing system 11 that may be used in any of the robotic systems 10, 10', 10". Fluid dispensing system 11 comprises a syringe 110, a nozzle or printing tip 125 attached to the end of the syringe through which ink/paste is dispensed, and an adapter assembly 115. Syringe 110 comprises a reservoir or syringe barrel 124, which is an elongated body, typically of circular section, designed to be filled with a fluid 128, such as ink, paste or adhesive. An external pressure regulator (not shown) may be used to apply an air inlet with certain pressure through the adapter assembly 115. Pressure regulator controls the applied pressure by means of a valve. Pressure (applied by compressed air in turn controlled by the external pressure regulator) actions a piston 122 which in turn pushes the ink 128. Ink is thus dispensed through the nozzle 125. Depending on the amount of air inlet applied with the pressure regulator, the pressure to be applied is adjusted. When a fluid 128 (i.e. ink) having very low viscosity is used, the pressure regulator may apply vacuum against the piston 122 in stand-by moments, that is to say, between consecutive depositions. Other mechanisms may be used. For example, when a fluid having high viscosity is used, a pressure multiplying mechanism -not shown- may be used (for example, multiplying pressure 7 times). The pressure to be applied in the syringe 110 depends on several factors, including the ink viscosity, the inner diameter of the dispensing tip and the thickness (depth) and width of the conductive path to be printed.

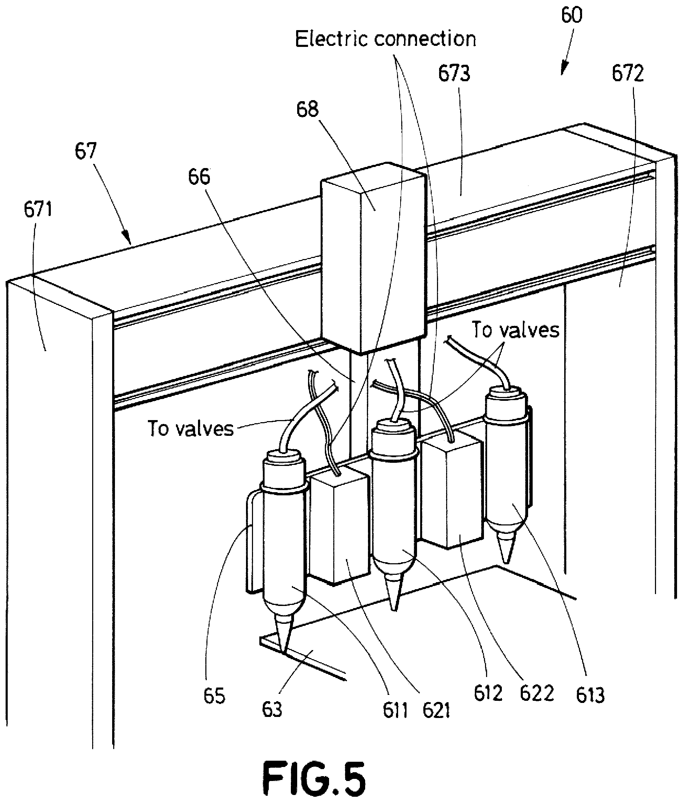

Figure 5 shows an alternative robotic system 60 that can be used in a method for obtaining a 3D part having an electrical conductive structure thereon, according to the present invention. Like robotic systems 10, 10' 10", robotic system 60 has a controller (not shown) similar to controller 14, which description applies to the controller of robotic system 60. Robotic system 60 also has a plate 63, such as a fixture plate or breadboard, on which the part on which an electronic assembly is going to be printed, may be disposed. It also comprises a support 67, similar to support 17 in robotic systems 10, 10', 10". Support 67 may be implemented with at least one elongated portion (vertical beam) 671 disposed perpendicular with respect to the surface on which the part is to be placed (i.e. plate 63), and one elongated portion 673 (horizontal beam) perpendicularly projecting from the upper end of elongated part 671. Parallel to the elongated portion 671, there may be a second elongated portion 672, the upper end of which is attached to the end of portion 673 not attached to portion 671. In this configuration, support 67 substantially takes the shape of an inverted U. Robotic system 60 also has a cartridge 68 slideably attached to horizontal beam 673. Cartridge 68 can move along the horizontal beam 673, that is to say, along X axis. Cartridge 68 comprises a lower portion 66 which enables movement in the Z axis, perpendicular to plate 63. In this embodiment, attached to portion 66, there is a support 65 in turn carrying plurality of printing assemblies 611-613, each of them comprising a syringe and a printing tip. Support 65 also carries other elements, such as lamps 621-622 and/or one or more pick&place heads. When cartridge 68 slides along the horizontal beam 673, elements attached to support 65 move in the X axis. Like in robotic system 10, plate 63 is movable in Y-axis (backwards and forwards). Support 65 (in particular, the lower portion 66 thereof) is vertically movable (in the Z axis), so that the printing assemblies and other elements come closer to or further from the 3D surface of the part disposed on the plate 63. Therefore, with the combination of the cartridge 68 movement along the horizontal beam 673, the vertical movement of portion 66 and the movement of the plate 63, the (x, y, z) positions ordered by controller 14 in order to follow the required printing trajectories, are reproduced. In the robotic system 60, there may also be sensing means (such as laser sensor, camera, scanner) for checking the distance between printing tip and surface of the part, and eventually adjusting the trajectories to be followed by the robotic system.

In this embodiment, a plurality of printing assemblies 611-613 is attached to support 65 and therefore to main support 67. Different printing assemblies 611-613 are used to deposit different types of functional inks or adhesives on the part disposed on plate 63 in order to obtain an electrical assembly. Printing assemblies 611-613 may be similar to the one shown in Figure 2 or different ones, depending on the circumstances (such as the width and depth of conductive path to be printed). With this configuration, different printing stages (such as depositing a conductive path, depositing a dielectric protection on the conductive part, applying adhesive to attach other components) of a process for printing an electrical conductive structure on a part, can be performed without requiring to interrupt the operation of the robotic system 60, and in particular without needing to decouple from the printing assembly the syringe used for, for example, dispensing a conductive ink, in order to couple to the printing assembly a different syringe for dispensing, for example, a dielectric ink on the previously deposited conductive ink, as is the case in the embodiment of Figure 1. There are at least three printing heads 611-613 with corresponding syringes and tips: a first printing assembly 611 for depositing conductive ink on a part disposed on plate 63, following a programmed trajectory (controlled by the robot controller); a second printing assembly 612 for depositing dielectric ink; and a third printing head for depositing on the part an adhesive.

In Figure 5, there is also at least one curing lamp 621-622 attached to support 65. The at least one lamp therefore moves while cartridge 68 slides along beam 673. In the shown embodiment, there is one IR lamp 621 for IR curing and one UV lamp 162 for UV curing. IR lamp 621 is usually employed for curing the conductive ink once it has been deposited by printing assembly 611. In turn, UV lamp 162 is usually employed for curing the dielectric ink once it has been deposited by printing assembly 612. Although not shown, robotic system 60 may also include a pick&place head attached to support 65, for example aligned with assemblies 611-613 and lamps 621-622, configured to automatically (according to programmed instructions managed by the robot controller) place additional components, such as lamps (i.e. LED lamps), sensors, buttons, switches, or the like, on a certain position on the part, in order to complete the electronic structure being printed.

The method for manufacturing an electronic assembly on a 3D part made of a PP-based substrate is explained next. It may be accomplished with a robotic system 10, 10', 10", 60. In the robot controller 14, a circuit pattern representing the different layers to be printed on the 3D part is stored. Usually, the circuit pattern has a first layer referring to a conductive path, which must be first deposited on the 3D part; a second layer referring to a dielectric path, which must be then deposited on the 3D part, covering the conductive path already deposited; and a third layer referring to adhesive and single components to be adhered on specific points on the already deposited layers. Depending on the part on which the printing will be applied (type of part, shape, dimensions, application for which the part is intended, etc.), a certain width of the conductive path is selected. In embodiments of the invention, the width of the conductive path may be within the following range: 0.1 - 4 mm, which is within the usual requirements for electronic assemblies printed on PP-based parts in certain industrial fields, such as the automotive and aeronautics industry. The depth of the conductive path may be within the following range: 0.04 - 0.65 mm. Therefore, the profile (area defined by width and depth) may be between 0.004 - 2.6 mm². It is remarked that, when working with 3D parts having complex curvatures, shapes or geometries, the width of the conductive path may vary within a part, in order to adapt to the mentioned characteristics of the 3D part. When the electronic assembly to be printed has physical components (LED lamps, etc.), the width of the conductive path may also depend on the location of these components on the part and on the distance between components, among others.

During the design of the different layers of the circuit pattern, a minimum gap between printed lines is preferably kept, such that potential inherent definition mistakes, for example associated to the roughness of the PP-based substrate, cause no impact on the final part or on the electronic assembly applied thereon. Such minimum gap may be of several microns, such as 50 µm, or 100 µm, or 200 µm, or 300 µm. In other words, the robotic system 10, 10', 10", 60, and in particular its controller 14, has been programmed by importing one or more patterns (such as DXF files). In a particular embodiment, DXF files import the (x,y) positions of the trajectory to be followed by the robotic system in order to print an electronic assembly on the selected 3D part. In this case, the height (Z-axis) must still be established. This may be done manually or automatically, depending on the capacity of the robotic system.

During application of the ink/paste to the surface of the 3D part using the fluid dispensing technique (micro-dispensing), the tip of the nozzle 125 (proximal end thereof) and the surface may be separated by a predetermined distance. The maximum distance may preferably be about 1 mm in order for the paste to properly adhere to the substrate (surface of the 3D part). In particular, the maximum distance may be about 900 µm, or about 800 µm, or about 700 µm, or less. In a particular embodiment, the minimum distance between tip of the nozzle and surface is defined as twice the average roughness of the surface.

Depending on the width of the conductive path to be printed, the value of certain parameters involved in the dispensing method, is selected. The conductive path(s) comprised in the electronic assemblies must have certain conductivity for its correct operation. The desired conductivity depends on several parameters, such as on the type of conductive ink used and on the curing temperature and time. This means that when designing the electronic assembly and selecting the conductive ink, the electrical resistance of the conductive path must also be taken into account, meaning that during the use of the electronic assembly printed on the PP-based part, the supplied voltage should not have a significant drop along the entire conductive path. This targeted electrical resistance is achieved through a correct selection of the conductive ink, which must have a sufficient amount of metallic particles (i.e. conductive particles) and a correct curing of the ink once dispensed.

A conductive ink (also referred to as low-temperature dryable conductive paste) is then selected, comprising metallic particles, a binder and an organic solvent. The amount of metallic particles in the conductive ink, required for achieving the required conductivity (i.e. not exceeding an electrical resistivity of 1000 mΩµm) in an electrical assembly printed on a PP-based part having a conductive path with width between 0.1 and 4 mm (or profile between 0.004 - 2.60 mm²), is 70-90 wt % (weight-%), preferably 74-90 wt%, such as 74-85% or 74-82%, or 76-82%. The metallic particles have an average size in the range of 50 nm to 50 µm. In embodiments in which the metallic particles are substantially spherical, the average size refers to the average diameter of the particles. It has been observed that conductive pastes having amounts of metallic particles and average sizes thereof within the mentioned ranges, when microdispensed from a maximum distance of about 900 µm and applying pressure of 0.2 - 13 bar, are correctly adhered to the substrate. On the contrary, in conventional methods using jet dispensing through a valve providing drop generation at a certain rate, such as the one disclosed in US10276937B2, high amounts of metallic particles or metallic particles of large size tend to block the nozzle. The metallic particles comprise silver. In embodiments of the invention, they are only made of silver. In alternative embodiments of the invention, they may combine silver and copper, for example they may be made of a silver core covered with copper.

The binder must be selected in such a way that it enhances the adhesion to the PP-based substrate and controls wettability. An organic binder is used. In a preferred embodiment, a binder based on polymeric resin is selected, in the range of 1 to 5 wt%, having a weight-average molar mass of 15000 to 60000. Higher molecular weights are discouraged because they increase chain entanglements resulting in an increased glass transition temperature (Tg) and viscosity. In terms of bulk adhesion, polymer-polymer interactions contribute to cohesive forces. The polymeric resin may have functional groups like hydroxyl and/or carboxyl groups that contribute to improving adhesion to the PP-based substrate.

The organic solvent is the diluent for the organic binder. Examples of suitable organic solvents may include alcohols, such as n-butanol and isopropanol; diols, such as ethylene glycol, propylene glycol, diethylene glycol and polyethylene glycol; ether alcohols; ethers, such as ethylene glycol di-C1-C6-alkyl ethers, propylene glycol di-C1-C6-alkyl ethers, diethylene glycol di-C1-C6-alkyl ethers, and dipropylene glycol di-C1-C6-alkyl ethers; ketones, such as acetone, methyl ethyl ketone, methyl propyl ketone, diethyl ketone, cyclohexanone, and methoxy hexanone; esters or ether esters, such as ethyl ethoxypropionate, ethyl glycol acetate, butyl diglycol acetate, methoxypropyl acetate, ethoxypropyl acetate, methoxybutyl acetate, methyl acetate, ethyl acetate, propyl acetate, butyl acetate, isobutyl acetate, diacetate, ethylene glycol diacetate, propylene glycol diacetate; terpenes, such as alpha- or beta-terpineol; hydrocarbons, such as kerosene, or any combination thereof. The organic solvent is preferably in the range of 4 to 29 wt%.

The ink may include one or more additives. The one or more additives may be in an amount of <1 wt %. Non-limiting examples of additives which may be included in the conductive paste composition are defoamers, rheology control agents and plasticizers to improve flexibility and make inks less brittle.

As explained, the selected conductive paste comprises between 70 and 90 wt % (preferably between 74 and 90 wt %, such as 74-85% or 74-82% or 76-82%) of metallic particles comprising silver, and the size of the metallic particles is between 50 nm and 50 µm. The selected conductive ink provides good adhesion to the PP-based material of which the 3D part is made, and good resistivity values in the conductive path to be printed assuming path width of between 0.1 and 4 mm -preferably between 0.25 and 4 mm-, (or path profiles between 0.004 - 2.6 mm²). The viscosity of the selected conductive paste is between 75 and 425 Pa-s measured with a rheometer at a temperature of 25°C and 1/s shear rate. From now on, unless indicated otherwise, viscosities are measured with a rheometer at a temperature of 25°C and 1/s shear rate.

A fluid dispensing system 11 is then selected, such that the selected conductive paste fills a syringe 110 of the fluid dispensing system 11. Reservoir or syringe barrel 124 may be of different sizes. For example, reservoirs of 3cc, 5cc, 10 cc, 20cc and 55cc may be selected. If an UV-cured ink is used, opaque reservoirs may be used. Different types of dispensing tips (nozzles) 125 may also be used. An important parameter to be taken into account in the selection of the nozzle 125 is its inner diameter because, together with the viscosity of the ink and the pressure to be applied thereto, it conditions the pattern (width and/or depth) of the path (i.e. conductive path) to be applied on the part. Non-limiting examples of internal diameters that the dispensing tip (nozzle) may have 125 are 0.1 mm, 0.15 mm, 0.20 mm, 0.25 mm, 0.33 mm, 0.41 mm, 0.51 mm, 0.61 mm, 0.84 mm, 1.2 mm, 1.36 mm, 1.54 mm, 2.2 mm, 2.7 mm, 3.4 mm and 3.8 mm. The internal diameter of the tip may be selected according to at least the dimensions of the ink path to be traced on the part. Other parameters of the nozzle 125 that may be taken into account are: material (for example it must be compatible with the ink to be dispensed); length; and whether it is straight or angled. The length and shape (straight or angled, for example) are specially relevant when 3 DoF robotic systems are used, in which no relative rotation or relative tilt between nozzle and part is possible; and/or when the 3D part is of high complexity. For example, when the part on which an electrical assembly is going to be printed, has a canal or groove on which the printing must be applied, the length and shape of the nozzle 125 is important. The nozzle 125 may be made of different materials, such as stainless-steel, polypropylene, polyethylene, PTFE, or others, and having different shapes, such as standard tip, conical, angled, chamfered, brush, or others. Thus, angles greater than 90° and complex curvatures can also be printed. Depending on the type of selected ink a dispensing tip 125 made of a certain material may be used in order to prevent chemical incompatibility. When the metallic particles comprised in the conductive ink comprise silver, the dispensing tip 125 is preferably made of stainless steel.

A nozzle (dispensing tip) 125 through which the conductive paste must be dispensed onto the surface of the 3D part, is selected. The nozzle 125 is then attached (e.g. screwed) to the syringe 110 filled with the selected paste. The syringe 110 is in turn coupled to the robotic system 10, 10', 10", 60. In order to print on a part made of a PP-based material with the selected ink, a nozzle 125 preferably made of steel (more preferably, stainless steel) is used. The nozzle 125 is selected according to at least its internal diameter.

In embodiments of the invention, the width of the printed line (conductive path) is at least several microns larger than the inner diameter of the selected nozzle. For this reason, preferably, the inner diameter of the nozzle 125 is selected to substantially correspond to the width of the conductive path to be printed. The inner diameter of the nozzle 125 is preferably selected to be as close as possible to the width of the conductive path to be printed, provided the inner diameter of the nozzle 125 is smaller than the width of the conductive path to be printed. In particular, for conductive path widths within the range of 0.1 and 0.3 mm, a nozzle having an inner diameter within the range of 0.1 and 0.25 mm is preferably selected; for conductive path widths within the range of 0.3 and 0.8 mm, a nozzle having an inner diameter within the range of 0.33 and 0.61 mm is preferably selected; and for conductive path widths within the range of 0.8 and 4 mm, a nozzle having an inner diameter within the range of 0.84 and 3.8 mm is preferably selected.

Once the nozzle 125 is selected according to its inner diameter, the pressure applied -for example by a valve- to the conductive paste 128 filling the syringe 110 (in particular, the syringe barrel 124) in order to control the dispensation through the selected nozzle 125, is selected. The pressure to be applied is dependent at least on the viscosity of the selected ink and on the inner diameter of the selected nozzle. It may also depend on the thickness of the conductive path to be deposited. The pressure is selected such that path widths between 0.1 and 4 mm (or path profiles varying between 0.004 - 2.6 mm²) are achieved.

In a particular embodiment, in which the viscosity of the selected conductive paste is between 75 and 105 Pa-s, the following pressure must be applied, depending on the inner diameter of the selected nozzle 125: If the inner diameter of the nozzle is between 0.1 and 0.3 mm, the applied pressure must be between 3 and 1 bar; if the inner diameter of the nozzle is between 0.3 and 1 mm, the applied pressure must be between 1 and 0.3 bar; if the inner diameter of the nozzle is between 1 and 4 mm, the applied pressure must be between 0.3 and 0.2 bar.

In a particular embodiment, in which the viscosity of the selected conductive paste is between 105 and 260 Pa-s, the following pressure must be applied, depending on the inner diameter of the selected nozzle 125: If the inner diameter of the nozzle is between 0.1 and 0.3 mm, the applied pressure must be between 7 and 2 bar; if the inner diameter of the nozzle is between 0.3 and 1 mm, the applied pressure must be between 2.5 and 0.4 bar; if the inner diameter of the nozzle is between 1 and 4 mm, the applied pressure must be between 0.5 and 0.3 bar.

In a particular embodiment, in which the viscosity of the selected conductive paste is between 260 and 425 Pa-s, the following pressure must be applied, depending on the inner diameter of the selected nozzle 125: If the inner diameter of the nozzle is between 0.1 and 0.3 mm, the applied pressure must be between 13 and 3 bar; if the inner diameter of the nozzle is between 0.3 and 1 mm, the applied pressure must be between 3 and 0.8 bar; if the inner diameter of the nozzle is between 1 and 4 mm, the applied pressure must be between 0.8 and 0.4 bar.

The different embodiments can be summarized in the following table:

| | Pressure | | |
|---|---|---|---|
| Inner diameter of the nozzle | Viscosity | Viscosity | Viscosity |
| | 260 - 425 Pa-s | 105 - 260 Pa-s | 75 - 105 Pa-s |
| 0.1 - 0.3 mm | 13 -3 bar | 7 - 2 bar | 3 - 1 bar |
| 0.3 - 1 mm | 3 - 0.8 bar | 2.5 - 0.4 bar | 1 - 0.3 bar |
| 1 - 4mm | 0.8 - 0.4 bar | 0.5 - 0.3 bar | 0.3 - 0.2 bar |

The 3D part is then placed on the fixture plate 13, 63. When the software (e.g. DXF files) has the (x,y) positions of the trajectory to be followed by the robotic system in order to print the electronic assembly on the 3D part, the height (Z-axis) may be established manually or automatically, depending on the capacity of the robotic system. In a particular embodiment, the height is fixed by manually measuring the distance between the dispensing tip (nozzle) 125 -already attached to the syringe, in turn attached to the robotic system, and the surface of the part. For example, the nozzle 125 is manually disposed on different points of the surface of the part and the resulting Z value (height) in each point is introduced in the software design (e.g. CAD design). The software design is thus aware of the (x, y, z) positions on which the printing must be done. Alternatively, the Z adjustment may be done with a sensor, thus avoiding the manual step of disposing the nozzle on different points of the part. In other words, the height (Z axis) has to be calibrated in different points to correct any offset introduced by the 3D shape of the PP-based part. Besides, if the robotic system has a camera or scanner, small alignments in (x, y) can be done during the printing of the part.

Optionally, once the conductive paste, the inner diameter of the nozzle and the pressure to be applied have been selected, in order to obtain the target width of conductive path, the speed of the robotic system 10, 10', 10", 60 may be adjusted. When selecting the printing speed, the complexity of the geometry of the 3D may also be taken into account. For example, when robotic system 10 in Figure 1 is used, the printing speed refers to the cartridge 18 movement (X) along the horizontal beam 173, the vertical movement (Z) of the printing assembly support and the movement (Y) of the plate 13. The joint printing speed of the robotic system may be adjusted between 3 and 20 mm/s, such as between 5 and 15 mm/s.

When the 3D part has complex curvatures, such as grooves, and/or when the robotic system has 3 axis (X, Y, Z), the length and shape of the nozzle must be carefully selected. For example, an angled-tip nozzle may be chosen in order to deposit the desired conductive paste on the correct surface of the 3D part (e.g. along a canal or groove). The part on which an electronic assembly is to be manufactured, may be a 3D part having any shape, including single curvature surfaces and double curvature surfaces. The outer surface of the 3D part may have geometrical irregularities, such as cavities, pores, grooves or an ornamental pattern. For this reason, in many occasions the printing head cannot attack in a perpendicular way the surface of the part on which it is dispensing ink or adhesive. This happens, for example, when a robotic system 10 having 3 DoF is used (Figure 1). Rather, the printing assembly should attack the surface of the part with a certain angle and/or with a curved tip in order to accomplish the printing without needing to substantially change the position and orientation of the part with respect to the robotic system. In this situation, in order to achieve this, fluids (inks or adhesives) having high viscosity (such as more than 105 Pa-s measured at 25° and 1/s shear rate, or preferably more than 120 Pa-s measured at 25° and 1/s shear rate) are preferably used. Alternatively, if possible, this difficulty may be addressed using a 4 DoF robotic system 10' (Figure 2) or a 5 DoF robotic system 10" (Figure 3). In the event the conductive path to be printed has changes of thickness or width along the target design, the nozzles can be changed accordingly, in which case the pressure to be applied is also adjusted.

Once the first layer (conductive path) is printed on the 3D part, the applied conductive ink is sintered (cured) following a thermal process, such that the volatile organic material in the solvent-organic binder medium is driven off. The organic binder (e.g. resin) is at least partially left to bind together the conductive particles, thus forming the electrically conducting lines. This may be done in different ways. In a possible embodiment, the part is introduced in an oven at a temperature of 110°C-170°C for certain time, such as between 5 minutes and 1.5 h. In another embodiment, in which a robotic system 60 is used (Fig. 5), the conductive ink applied on the part is dried without removing the part from the plate 63. In this case, lamp 621 (such as an IR lamp) cures the printing. For example, but not limiting, a 200 W lamp having up to 90 W/cm² may be used for a certain time, such as between 30 s and 5 minutes.

Once the conductive ink defining the conductive paths has been applied on the surface of the PP-based substrate and dried, a dielectric path is deposited thereon to protect the conductive paths. To ensure good coverage of the conductive paths, the width of the dielectric layer must be the same as or -preferably- a bit larger than the width of the conductive paths. The dielectric ink, also referred to as encapsulated ink, is preferably a polymeric dielectric ink. The selected polymeric dielectric ink is preferably a 100% solid ink after curing. Non-limiting examples of polymeric dielectric materials that may be used as dielectric ink are: poly (4-vinylphenol) (PVP), poly (methyl methacrylate), Polyethylene Terephthalate, polyimide, Polyvinyl alcohol, Polystyrene, poly(vinyl pyrollidone), poly(vinyl chloride) and polyamides. The dielectric ink is also used for the final encapsulation of printed devices. In the event the part has been dried in an oven, the part is placed again on the fixture plate. Otherwise (if the part has been dried using a lamp 621), there is no need to move the part. The print trajectories are then imported.

Once the dielectric ink has been selected, a nozzle (dispensing tip) through which the dielectric ink must be dispensed onto the surface of the 3D part, covering the conductive path already applied, is selected. The nozzle will be then attached (e.g. screwed) to the syringe filled with the selected ink. The syringe is in turn coupled to the robotic system 10, 10', 10", 60. In order to print on a part made of a PP-based material with the selected ink, a nozzle made of steel (preferably, stainless steel) may be used. Nozzles made of other materials may be used alternatively. The nozzle is selected according to its internal diameter, which in turn must be selected taking into account that the dielectric path must be at least as wide as the conductive path. In a preferred embodiment, the width of the dielectric path is a few microns larger (such as 20 µm, or 50 µm, or 100 µm, or 200 µm) than the width of the conductive path. The thickness of the dielectric path may be similar to the thickness of the conductive path. In sum, the profile of the dielectric path may be approximately between 0.005 and 2.7 mm². The inner diameter of the nozzle may be selected to be between 0.1 and 3.8 mm. Another parameter to be fixed is the pressure applied -for example by a valve- to the dielectric ink filling the syringe in order to control the dispensation through the selected nozzle. The pressure to be applied is dependent on the selected ink and on the inner diameter of the selected nozzle. The pressure is selected such that conductive path profiles varying between 0.004 and 2.6 mm² are totally covered by the dielectric path applied thereon. The former table which indicates values of pressure to be applied depending on the inner diameter of the nozzle and on the ink viscosity, may be applied to select the pressure to be applied when microdispensing the dielectric ink.

Optionally, once the type of dielectric ink, the inner diameter of the nozzle and the pressure to be applied have been selected, the speed of the robotic system 10, 10', 10", 60 may be adjusted. The speed of the robotic system is preferably adjusted between 3 and 30 mm/s. The speed may also depend on the complexity of the surface of the 3D part and on the design of the electronic assembly.

Once the second layer (dielectric path) is applied on the 3D part, the applied dielectric ink is sintered (cured). This may be done in different ways. In a possible embodiment, in which a robotic system 60 is used (Fig. 5), the dielectric ink applied on the part is dried without removing the part from the plate 63. In this case, lamp 622 (such as an IR lamp) cures the printing. For example, but not limiting, an IR lamp having optimum cure of 650 mJ/cm² is used for a certain time, such as between 20-60 seconds at a distance of between 50 - 500 mm. In another embodiment, in which a robotic system 10, 10', 10" is used, not having an UV lamp attached thereto, the part is taken to a different location and cured in an oven in a temperature range between 100-175° for a time of between 2 minutes an 2 hours.

Finally, other electronic components may be added to the printed circuit. This may be done using a hybrid system, meaning that one or more pick&place heads, controlled by the robot controller, can be used to position non-printed devices like LEDs (that may be inserted (Through-hole), glued (SMD), etc.) or connectors (Flexible Flat Cables (FFC): FFC connectors or Clincher connectors) using different junction and connecting strategies (Isotropic conductive adhesives and Anisotropic conductive film adhesives (based on thermoplastic and thermoset adhesives randomly loaded with conductive particles)).

Therefore, in the event other electronic components, such as rigid components, need to be included in the electronic assembly, once the dielectric path has been cured, an adhesive is deposited on specific positions in the part (according to the pattern defined in the imported trajectories). For example, the other electronic components to be added to the printed circuit, may be LEDS and a flexible flat cable. The adhesive is preferably an electrically conductive adhesive. In a non-limiting example, the adhesive comprises between 75 and 77 wt % (weight-%) silver particles, one or more additives and one or more organic solvents. This formulation provides good adhesion between components (e.g. SMD LEDS) and the silver conductive adhesive after heat curing in a preferred temperature range of 100 to 140°C in an oven. The viscosity of the adhesive may be in the range of 40 to 90 Pa-s measured with a rheometer at a temperature of 25°C and 0.161/s shear rate. A deposition of adhesive -for example a drop- is deposited on the point on the surface of the 3D part on which an electronic component must be placed. Preferably, the inner diameter of the nozzle used to deposit the adhesive is between 0.33 and 0.61 mm. Preferably, the pressure applied to deposit the adhesive is between 0.6 and 1.5 bar. Once the electronic component is placed on the adhesive and therefore glued to its position on the 3D part, the adhesive is cured. It may be cured in an oven, for example at 120°C for 20 minutes.

The method of the present invention permits to print electronic assemblies on PP-based 3D parts having complex curvatures. Areas larger than several square meters can be printed with high accuracy.

### EXAMPLES

Example 1: An electronic assembly has been dispensed on a door bezel 70 as shown in figure 6a. It has a complex 3D geometry with double curvatures. The door bezel is made of a PP-glass fibre composite having 16% talc. A robotized printing head based on micro-dispensing is used to print the conductive tracks 71 and capacitive touch button 73 shown in figure 6b. The conductive ink is a Ag-based conductive paste having 78% in weight of Ag particles, size of particles of 400-600 nm and viscosity of 118 Pa-s. It is dispensed with a nozzle having an inner diameter of 0.61mm at 10-15mm/s printing speed applying 0.7 - 0.9 bar. Once deposited on the surface of the door bezel, the conductive paths 71 and printed capacity touch buttom 73 are cured at 130°C for 30min. A dielectric ink is then applied, covering the conductive paths and buttom, having viscosity of 89 Pa-s, dispensed with a nozzle having an inner diameter of 0.61mm at 10-15mm/s printing speed applying 0.7 - 0.9 bar. Conductive lines crossovers are solved using UV curing dielectric applied by a UV lamp for 60sec optimum cure of 650mJ/m² at 150mm distance. A LED was then placed on a previously applied adhesive. The adhesive is a conductive adhesive applied at a pressure of 1 bar with a nozzle having inner diameter of 0.51 mm. It is cured in an oven at 120°C for 20 minutes. A portion of the electronic assembly made on the 3D part 70 (figure 6a) is shown in detail in figure 6b, which substantially corresponds to the portion of the part 70 identified with a dotted line in figure 6a.
Example 2: An electronic assembly has been dispensed on a headlight housing 90 as shown in figure 8a. It has very narrow parts. The headlight housing 90 is made of a PP-glass fibre composite having 20% (%w) short glass fiber. It has with an average roughness of 2 µm. A robotized printing head based on micro-dispensing is used to print conductive tracks 91 as shown in figure 8b, on channels of 1cm width and 8mm depth made in the PP-based part. These channels were made during the injection molding process under which the part 90 was made. The conductive ink is an Ag-based conductive paste having 81.5% in weight of Ag particles, size of particles of 1-2 µm and viscosity of 405 Pa-s. It is micro-dispensed with a nozzle having an inner diameter of 0.61mm at 10 mm/s printing speed applying pressure of 1 bar. The conductive lines have been cured at 130°C for 30h in an oven. A dielectric ink having viscosity of 89 Pa-s is applied on the conductive paths 91, dispensed with a nozzle having an inner diameter of 0.61mm at 10-15mm/s printing speed applying 0.7 - 0.9 bar. SMD LEDs 92 and resistance 93 have been placed on specific places on the path 91. The paths have been cured at 130°C for 30h in an oven while the LEDs had already been adhered to the tracks. A portion of the electronic assembly made on the headlight housing 90 (figure 8a) is shown in detail in figure 8b, which substantially corresponds to the portion of the part 90 identified with a dotted line in figure 8a.
Example 3: An electronic assembly has been dispensed on a rear mirror view bracket 70 as shown in figures 7a-7b. It has a double curvature 3D geometry. The rear mirror view bracket 80 is made of a PP with 24% short glass fibre with an average roughness of 100µm. A robotized printing head based on micro-dispensing is used to print conductive tracks 85 as shown in figure 7c on the PP-based part 80. The conductive ink is an Ag-based conductive paste having 78% in weight of Ag particles, size of particles of 400-600 nm and viscosity of 118 Pa-s. It is micro-dispensed with a nozzle having an inner diameter of 0.61mm at 7 mm/s printing speed applying pressure of 0.9 bar. Conductive lines crossovers are solved using UV curing dielectric applied by a UV lamp for 40sec with optimum cure of 650mJ/m² at 100mm distance. A portion of the electronic assembly made on the 3D part 80 (figure 7b) is shown in detail in figure 7c, which substantially corresponds to the portion of the part 80 identified with a dotted line in figure 7c.

In summary, the proposed method allows obtaining injection molded or machined 3D parts made of a PP-based material and having printed (such as micro-dispensed) electric conductive structures, including sensing elements and cabling, disposed directly on the surface of the PP-based part. The method includes applying different printing layers with an automatic digital system.

The invention is obviously not limited to the specific embodiment(s) described herein, but also encompasses any variations that may be considered by any person skilled in the art (for example, as regards the choice of materials, dimensions, components, configuration, etc.), within the general scope of the invention as defined in the claims.

## Claims

1. A method of applying an electronic assembly on a 3D part made of a polypropylene-based material, the electronic assembly comprising at least one electrically conductive path having width between 0.1 and 4 mm, the method comprising:
providing a 3D part made of a polypropylene-based material;
selecting a conductive paste comprising: metallic particles comprising silver, a binder and an organic solvent; the amount of binder being between 1 to 5 wt%; the amount of metallic particles being between 74 to 90 wt%, the metallic particles having an average size between 50nm to 50µm; wherein the viscosity of the conductive paste is between 75 and 425 Pa-s measured with a rheometer at a temperature of 25°C at 1/s shear rate;
providing a fluid dispensing system (11) for applying the conductive paste onto a surface of the 3D part;
selecting a nozzle (125) and attaching the selected nozzle (125) to the fluid dispensing system (11), through which the selected conductive paste is to be dispensed, wherein the nozzle (125) is selected such that its inner diameter is as close as possible to the width of the conductive path to be applied, the inner diameter of the nozzle (125) being smaller than the width of the conductive path to be applied;
dispensing the selected conductive paste on to the surface of the 3D part through said nozzle (125) by applying a pressure between 0.2 and 13 bar, while maintaining a maximum distance of 900 µm between the nozzle (125) and the surface of the 3D part;
curing the deposited conductive paste;
depositing a dielectric ink on the printed conductive path;
curing the deposited dielectric ink;
attaching at least one electronic component on the conductive path.

2. The method of claim 1, wherein when the viscosity of the selected conductive paste is between 75 and 105 Pa-s, the selected conductive paste is dispensed on to the surface of the 3D part as follows:
if the inner diameter of the selected nozzle (125) is between 0.1 and 0.3 mm, applying a pressure on the conductive ink between 3 and 1 bar;
if the inner diameter of the selected nozzle (125) is between 0.3 and 1 mm, applying a pressure on the conductive ink between 1 and 0.3 bar;
if the inner diameter of the selected nozzle (125) is between 1 and 4 mm, applying a pressure on the conductive ink between 0.3 and 0.2 bar.

3. The method of claim 1, wherein when the viscosity of the selected conductive paste is between 105 and 260 Pa-s, the selected conductive paste is dispensed on to the surface of the 3D part as follows:
if the inner diameter of the selected nozzle (125) is between 0.1 and 0.3 mm, applying a pressure on the conductive ink between 7 and 2 bar;
if the inner diameter of the selected nozzle (125) is between 0.3 and 1 mm, applying a pressure on the conductive ink between 2.5 and 0.4 bar;
if the inner diameter of the selected nozzle (125) is between 1 and 4mm, applying a pressure on the conductive ink between 0.5 and 0.3 bar.

4. The method of claim 1, wherein when the viscosity of the selected conductive paste is between 260 and 425 Pa-s, the selected conductive paste is dispensed on to the surface of the 3D part as follows:
if the inner diameter of the selected nozzle (125) is between 0.1 and 0.3 mm, applying a pressure on the conductive ink between 13 and 3 bar;
if the inner diameter of the selected nozzle (125) is between 0.3 and 1 mm, applying a pressure on the conductive ink between 3 and 0.8 bar;
if the inner diameter of the selected nozzle (125) is between 1 and 4mm, applying a pressure on the conductive ink between 0.8 and 0.4 bar.

5. The method of any one of claims 1-4, wherein the dielectric ink is a polymeric dielectric ink comprising at least one of: poly (4-vinylphenol) (PVP), poly (methyl methacrylate), Polyethylene Terephthalate, polyimide, Polyvinyl alcohol and Polystyrene.

6. The method of any one of claims 1-5, wherein the at least one electronic component is adhered by means of an adhesive deposited on a corresponding position on the conductive path.

7. The method of any one of claims 1-6, wherein the at least one electronic component is one of a LED, a cable, a connector and a sensors.

8. The method of any one of claims 1-7, wherein the binder comprised in the conductive paste is based on a polymeric resin.

9. The method of any one of claims 1-8, wherein the conductive paste is deposited with an angled-tip nozzle.

10. The method of any one of claims 1-9, wherein the deposited conductive paste is cured in an oven at a temperature of 130°C-170°C for between 5 minutes and 1,5 h.

11. The method of any one of claims 1-9, wherein the deposited conductive paste is cured using an IR lamp.

12. The method of any one of claims 1-11, wherein the deposited dielectric ink is cured using an UV lamp for 20-60 seconds.

13. The method of any one of claims 1-12, wherein the polypropylene-based material is one of the following: a thermoplastic polyolefin (TPO); a PP copolymer; a colored PP; an Engineering-filled polypropylene (EFPP); a new generation of PP; and a PP-glass fibre composite.
